# EUROPEAN PATENT APPLICATION

(11) **EP 3 054 484 A1**
(43) Date of publication of application: **10.08.2016**
(21) Application number: 16154934.0
(22) Date of filing: 09.02.2016
(51) Int. Cl.: H01L 27/12

(54) **THIN FILM TRANSISTOR SUBSTRATE, DISPLAY APPARATUS INCLUDING THIN FILM TRANSISTOR SUBSTRATE, METHOD OF MANUFACTURING THIN FILM TRANSISTOR SUBSTRATE, AND METHOD OF MANUFACTURING DISPLAY APPARATUS**

(30) Priority: 09.02.2015 KR 20150019663
(71) Applicant: Samsung Display Co., Ltd., Gyeonggi-do (KR)
(72) Inventor: KIM, Hyunchul, Gyeonggi-do (KR)
(74) Representative: Mounteney, Simon James

(57) **Abstract**

A thin film transistor (TFT) substrate, including a substrate; a TFT on the substrate; and an insulating layer including at least one dummy hole, the at least one dummy hole in one or more of an upper area of the TFT or a peripheral area of the TFT, a material buried in the at least one dummy hole being an insulating material different from a material of the insulating layer.

## Description

### BACKGROUND

### 1. Field

One or more embodiments of the invention relate to a thin film transistor (TFT) substrate, a display apparatus including the TFT substrate, a method of manufacturing the TFT substrate, and a method of manufacturing the display apparatus.

### 2. Description of the Related Art

A thin film transistor (TFT) substrate may refer to a structure in which at least one TFT is formed on a substrate. A display apparatus may be manufactured by using the TFT substrate.

A TFT in a TFT substrate may be an active layer that may include a crystalline silicon layer. The crystalline silicon layer may be formed by crystallizing an amorphous silicon layer, and properties of the TFT may be determined according to the crystallizing method. Different ranges of the properties of the TFT may be required according to a function of the TFT in a circuit.

In a comparative TFT substrate, it may not be convenient to modify properties of a TFT according to a function of the TFT in a circuit. In a display apparatus including such a TFT substrate, images may be displayed with different brightnesses even when identical electric signals are applied to a plurality of pixels.

The present invention sets out to provide a TFT substrate in which properties of a TFT such as mobility may be adjusted, a display apparatus including the TFT substrate, a method of manufacturing the TFT substrate, and a method of manufacturing the display apparatus.

### SUMMARY

Embodiments of the invention may be realized by providing a thin film transistor (TFT) substrate, including a substrate; a TFT on the substrate; and an insulating layer including at least one dummy hole, the at least one dummy hole in one or more of an upper area of the TFT or a peripheral area of the TFT, a material buried in the at least one dummy hole being an insulating material different from a material of the insulating layer.

The insulating layer may include at least one contact hole in which a conductive material is buried.

A width of the at least one dummy hole may have a substantially same width as the at least one contact hole.

The TFT may include an active pattern on the substrate and a gate electrode that overlaps at least one portion of the active pattern, the TFT substrate further may include a conductive layer that is electrically connected to the active pattern via the conductive material buried in the at least one contact hole, and the insulating layer may be an interlayer insulating layer between the gate electrode and the conductive layer.

The TFT substrate may further include a planarizing layer that covers the insulating layer and the conductive layer. A portion of the planarizing layer may be buried in the at least one dummy hole.

The TFT substrate may further include a gate insulating layer between the active pattern and the gate electrode. The at least one dummy hole may include a first dummy hole that penetrates through the gate insulating layer and extends to an upper surface of the substrate.

The at least one dummy hole may include a second dummy hole that extends to an upper surface of the gate electrode.

The TFT substrate may further include a first gate insulating layer between the active pattern and the gate electrode, the first gate insulating layer including silicon oxide; and a second gate insulating layer between the first gate insulating layer and the gate electrode, the second gate insulating layer including silicon nitride.

The gate electrode may include aluminum (Al).

The TFT may include an active pattern on the substrate and a gate electrode that overlaps at least one portion of the active pattern, and the TFT substrate may further include a first conductive layer on the gate electrode, the first conductive layer including an upper electrode that overlaps at least one portion of the gate electrode; and a second conductive layer including a power line that is electrically connected to the upper electrode via the conductive material buried in the at least one contact hole, the power line applying a power voltage to the upper electrode. The upper electrode and the gate electrode may form a capacitor, and the insulating layer may be an interlayer insulating layer between the first and second conductive layers.

The TFT substrate may further include a planarizing layer that covers the insulating layer and the second conductive layer. A portion of the planarizing layer may be buried in the at least one dummy hole.

The TFT substrate may further include a gate insulating layer between the active pattern and the gate electrode; and a dielectric layer between the gate electrode and the first conductive layer. The at least one dummy hole may include a first dummy hole that penetrates through the gate insulating layer and the dielectric layer and extends to an upper surface of the surface.

The at least one dummy hole may include a second dummy hole that extends to an upper surface of the upper electrode.

The insulating layer may include an inorganic insulating material, and the material buried in the at least one dummy hole may be an organic insulating material.

The dummy hole may be circular, oval, or polygonal shaped.

Embodiments may be realized by providing a display apparatus, including the thin film transistor (TFT) substrate; and a display device on the TFT substrate.

Embodiments may be realized by providing a method of manufacturing a thin film transistor (TFT) substrate, the method including forming a TFT on a substrate; forming an insulating layer including at least one dummy hole in one or more of an upper area of the TFT or a peripheral area of the TFT; and burying, in the at least one dummy hole, an insulating material different from a material of the insulating material.

Forming the insulating layer may include forming the insulating layer such that the insulating layer may include the at least one dummy hole and at least one contact hole, and the method may further include burying a conductive material in the at least one contact hole.

Forming the insulating layer may include forming the at least one dummy hole and at least one contact hole to have substantially a same width.

Forming the TFT may include forming an active pattern on the substrate, and forming a gate electrode such that the gate electrode overlaps at least one portion of the active pattern, burying the conductive material in the at least one contact hole may include forming a conductive layer electrically connected to the active pattern via the conductive material buried in the at least one contact hole, and forming the insulating layer may include forming an interlayer insulating layer between forming the gate electrode and forming the conductive layer.

The method may further include forming a planarizing layer that covers the insulating layer and the conductive layer. A portion of the planarizing layer may be buried in the at least one dummy hole.

The method may further include forming a gate insulating layer between forming the active pattern and forming the gate electrode. Forming the insulating layer may further include forming a first dummy hole that penetrates through the gate insulating layer and extends to an upper surface of the substrate.

Forming the insulating layer may include coating an insulating material on the substrate; and forming a second dummy hole that extends to an upper surface of the gate electrode.

Forming the insulating layer may include forming an insulating layer that may include an inorganic insulating material, and the material buried in the at least one dummy hole may be an organic insulating material.

The dummy hole may be circular, oval, or polygonal shaped.

Embodiments may be realized by providing a method of manufacturing a display apparatus, the method including preparing a thin film transistor (TFT) substrate; and forming a display device on the TFT substrate.

At least some of the above and other features of the invention are set out in the claims.

### BRIEF DESCRIPTION OF THE DRAWINGS

Features of the invention will be made more apparent to those of skill in the art by describing in detail embodiments thereof with reference to the attached drawings in which:
FIG. 1 illustrates a schematic plan view of a thin film transistor (TFT) substrate according to an embodiment of the invention;
FIG. 2 illustrates a schematic cross-sectional view of the TFT substrate of FIG. 1 cut along a line II-II of FIG. 1;
FIG. 3 illustrates a schematic cross-sectional view of the TFT substrate of FIG. 1;
FIG. 4 illustrates a schematic plan view of a TFT substrate according to an embodiment of the invention;
FIG. 5 illustrates a schematic cross-sectional view of the TFT substrate of FIG. 4 cut along a line IV-IV of FIG. 4;
FIG. 6 illustrates a schematic cross-sectional view of the TFT substrate of FIG. 4;
FIG. 7 illustrates a conceptual view of a portion VII of FIG. 6; and
FIGS. 8 to 12 illustrate schematic cross-sectional views of a method of manufacturing the TFT substrate of FIG. 1.

### DETAILED DESCRIPTION

Example embodiments of the invention will now be described more fully hereinafter with reference to the accompanying drawings; however, the invention may be embodied in different forms and should not be construed as limited to the embodiments set forth herein. Rather, these embodiments are provided so that this disclosure will be thorough, and will convey implementations to those skilled in the art.

As used herein, the term "and/or" includes any and all combinations of one or more of the associated listed items. Expressions such as "at least one of," when preceding a list of elements, modify the entire list of elements and do not modify the individual elements of the list. Like reference numerals in the drawings denote like elements, and thus their description will not be repeated.

It will be understood that although the terms "first," "second," etc., may be used herein to describe various components, these components should not be limited by these terms. These components are only used to distinguish one component from another. As used herein, the singular forms "a," "an" and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components. It will be understood that when a layer, region, or component is referred to as being "formed on" another layer, region, or component, it can be directly or indirectly formed on the other layer, region, or component. That is, for example, intervening layers, regions, or components may be present.

Sizes of components in the drawings may be exaggerated for convenience of explanation. In other words, since sizes and thicknesses of components in the drawings are arbitrarily illustrated for convenience of explanation, the following embodiments are not limited thereto.

In the following examples, the x-axis, the y-axis and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

When a certain embodiment may be implemented differently, a specific process order may be performed differently from the described order. For example, two consecutively described processes may be performed substantially at the same time or performed in an order opposite to the described order.

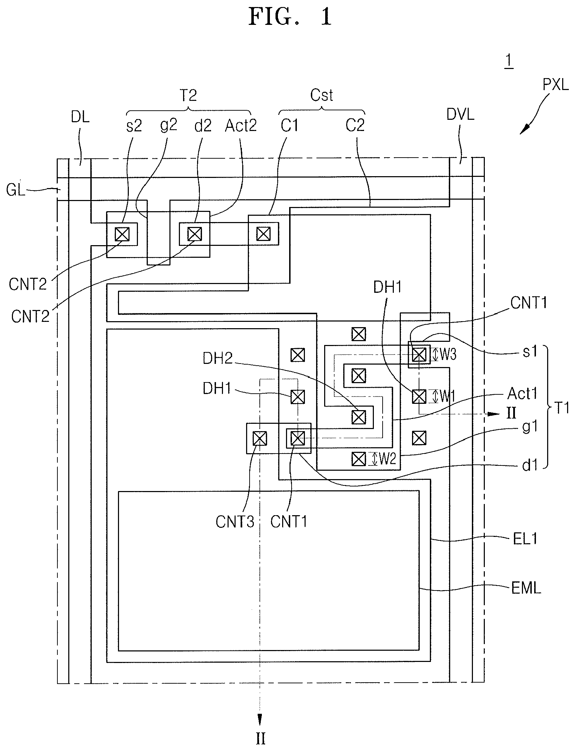

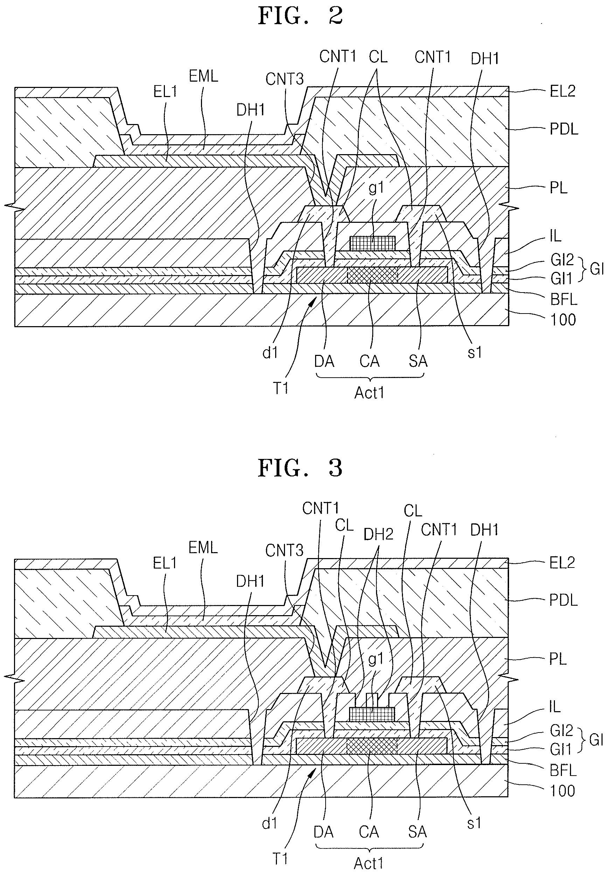

FIG. 1 illustrates a schematic plan view of a thin film transistor (TFT) substrate structure 1 according to an embodiment. FIG. 2 illustrates a schematic cross-sectional view of the TFT substrate structure 1 of FIG. 1 cut along a line II-II of FIG. 1;

Referring to FIGS. 1 and 2, the TFT substrate structure 1 according to an embodiment of the invention may include a substrate 100, a TFT T1, and an insulating layer IL that may include first and second dummy holes DH1 and DH2.

The substrate 100 may be formed of various materials, for example, a glass material, a metallic material, or a plastic material such as polyethylene terephthalate (PET), polyethylene naphthalate (PEN), and polyimide. The substrate 100 may include a display area in which a plurality of pixels PXL are disposed, and a peripheral area that surrounds the display area.

At least one pixel PXL, which may display an image, may be provided on the substrate 100. When there is a plurality of pixels PXL, the pixels PXL may be arranged in a matrix form. Only one pixel PXL is illustrated in the present embodiment for convenience of description. In an embodiment, the pixel PXL may be rectangular-shaped, as shown in FIG. 1. In an embodiment, a shape of the pixel PXL may be modified in various ways. The pixels PXL may have different sizes. For example, the pixels PXL with different colors may have different sizes or shapes according to a color of each pixel PXL.

The pixel PXL may include a wiring portion that may include a gate line GL, a data line DL, and a driving voltage line DVL, TFTs T1 and T2 connected to the wiring portion, an organic light emitting device (OLED) connected to the TFTs T1 and T2, and a capacitor Cst.

The gate line GL may extend in one direction, and the data line DL may extend in another direction that intersects the gate line GL. The driving voltage line DVL may extend in substantially the same direction as the data line DL. The gate line GL may transmit scan signals to the TFTs T 1 and T2, the data line DL may transmit data signals to the TFTs T1 and T2, and the driving voltage line DVL may supply driving voltages to the TFTs T1 and T2.

The TFT T1 may be referred to as a driving TFT T1 that may control the OLED, and the TFT T2 may be referred to as a switching TFT T2 that switches the driving TFT T1. According to an embodiment, the pixel PXL may include, for example, two TFTs T1 and T2. The pixel PXL may include one TFT and one capacitor, or include three or more TFTs and two or more capacitors.

The driving TFT T1 may include a first gate electrode g1, a first source electrode s1, and a first drain electrode d1. The first gate electrode g1 may be connected to the switching TFT T2, the first source electrode s1 may be connected to the driving voltage line DVL, and the first drain electrode d1 may be connected to the OLED.

At least one dummy hole may be formed in an upper area or a peripheral area of the driving TFT T1. The first and second dummy holes DH1 and DH2 may be formed in the insulating layer IL. According to embodiments, the first and second dummy holes DH1 and DH2 may extend to a layer under the insulating layer IL. The first and second dummy holes DH1 and DH2 may not be electrically connected to the driving TFT T1 or to any device or wiring around the TFT T1, and a material buried in the first and second dummy holes DH1 and DH2 may be an insulating material that is different from a material used to form the insulating layer IL, where the first and second dummy holes DH1 and DH2 are located.

The switching TFT T2 may include a second gate electrode g2, a second source electrode s2, and a second drain electrode d2. The second gate electrode g2 may be connected to the gate line GL, and the second source electrode s2 may be connected to the data line DL. The second drain electrode d2 may be connected to a gate electrode of the driving TFT T1 (i.e., the first gate electrode g1). The switching TFT T2 may transmit the data signals that are applied to the data line DL to the driving TFT T1 according to the scan signals that are applied to the gate line GL.

A display device may be arranged on the TFT substrate structure 1. In an embodiment, an OLED may be arranged as the display device according to the present embodiment. A liquid crystal display (LCD) may be arranged as the display device. The OLED may include an emission layer EML, and a first electrode EL1 and a second electrode EL2 that may face each other with the emission layer EML disposed therebetween. The first electrode EL1 may be connected to the first drain electrode d1 of the driving TFT T1. A common voltage may be applied to the second electrode EL2, and the emission layer EML may display an image by emitting light according to output signals of the driving TFT T1.

The capacitor Cst may be connected to an area between the first gate electrode g1 and the first source electrode s1 of the driving TFT T1, and may charge and maintain the data signals that are input to the first gate electrode g1 of the driving TFT T1.

Hereinafter, referring to FIG. 2, the TFT substrate structure 1 according to an embodiment of the invention will be described according to a stacking order.

The TFT substrate structure 1 according to an embodiment may include the substrate 1 substrat structure 100 that may have an insulating property. The TFTs T 1 and T2 and the capacitor Cst may be stacked on the substrate 100. An LCD or an OLED may be arranged on the TFT substrate structure 1. The present embodiment discloses an example in which the OLED may be arranged on the TFT substrate structure 1.

Referring to FIG. 2, a buffer layer BFL may be disposed on the substrate 100. The buffer layer BFL may planarize an upper surface of the substrate 100 or block impurities from spreading in the driving TFT T1. The buffer layer BFL may be formed of, for example, silicon nitride, silicon oxide, or silicon oxynitride. The buffer layer BFL may be omitted according to a material of the substrate 100 and manufacturing conditions.

A first active pattern Act 1 may be disposed on the buffer layer BFL. The first active pattern Act1 may be formed of a semiconductor material and include amorphous silicon, polycrystalline silicon, or an organic semiconductor material. The first active pattern Act 1 may function as an active layer of the driving TFT T1. The first active pattern Act1 may include a source area SA, a drain area DA, and a channel area CA provided between the source and drain areas SA and DA. The source and drain areas SA and DA of the first active pattern Act1 may be doped with n-type or p-type impurities.

A gate insulating layer GI may be disposed on the first active pattern Act1. The gate insulating layer GI may be formed of, for example, silicon oxide and/or silicon nitride, and the first active pattern Act1 may be insulated from the first gate electrode g1.

According to the present embodiment, the gate insulating layer GI may have a multi-layer structure. As shown in FIG. 2, the gate insulating layer GI may include a first gate insulating layer GI1 and a second gate insulating layer GI2. The gate insulating layer GI may be formed as a multi-layer structure to prevent the gate insulating layer GI from being etched when patterning the first gate electrode g1.

The first gate insulating layer GI1 may be provided between the first active pattern Act1 and the first gate electrode g1, and may include silicon oxide. The second gate insulating layer GI2 may be provided between the first gate insulating layer GI1 and the first gate electrode g1, and may include silicon nitride. The second gate insulating layer GI2 may be formed above the first gate insulating layer GI1. The second gate insulating layer GI2 including silicon nitride may be relatively more resilient to an etching solution than the first gate insulating layer GI1 including silicon oxide, and the gate insulating layer GI may be less damaged when patterning the first gate electrode g1.

The first gate electrode g1 may be disposed on the gate insulating layer GI. The first gate electrode g1 may overlap at least one portion of the first active pattern Act1. The first gate electrode g1 may be disposed to cover an area of the second gate insulating layer GI2 which may correspond to the channel area CA of the first active pattern Act1. The first gate electrode g1 may be formed by using a metallic material with regard to conductivity. According to the present embodiment, the first gate electrode g1 may include aluminum (Al). Al may provide a better manufacturing margin than other metallic materials, and Al may be useful for manufacturing a TFT substrate that may display a high-resolution image.

The insulating layer IL may be disposed on the first gate electrode g1 to cover the first gate electrode g1. The insulating layer IL may be referred to as an interlayer insulating layer IL. Such an interlayer insulating layer IL may be formed as a single layer or multiple layers of silicon oxide or silicon nitride.

The interlayer insulating layer IL may include at least one contact hole in which a conductive material is buried. A conductive material buried in the contact hole CNT1 may be regarded as a conductive layer CL that may form the first source electrode s1 and the first drain electrode d1 of the driving TFT T1. The first electrode EL1 of the OLED and the driving TFT T1 may be electrically connected to each other via the conductive material buried in the contact hole CNT1.

The interlayer insulating layer IL may include at least one first dummy hole DH1 in a peripheral area of the driving TFT T1. The first dummy hole DH1 may penetrate through the gate insulating layer GI and extend to an upper surface of the substrate 100. A location of the first dummy hole DH1 may not be limited to locations shown in FIGS. 1 and 2. Any number of first dummy holes DH1 may be located anywhere in the peripheral area of the driving TFT T1. FIG. 1 illustrates that the first dummy hole DH1 may be square-shaped. In an embodiment, the first dummy hole DH1 may be circular, oval, or polygonal shaped.

A material buried in the first dummy hole DH1 may be different from a material of the interlayer insulating layer IL. A planarizing layer PL on the interlayer insulating layer IL may be buried in the first dummy hole DH1. The first dummy hole DH1 may not be electrically connected to any wiring or device in the TFT substrate structure 1. A width W1 of the first dummy hole DH1 may be substantially the same as a width W3 of the contact hole CNT 1.

The first source and drain electrodes s1 and d1, i.e., the conductive layer CL, may be disposed on the interlayer insulating layer IL. Referring to FIG. 1, the first source and drain electrodes s1 and d1 respectively may contact a source area and a drain area of a second active pattern Act2 via the contact hole CNT1 formed in the gate insulating layer GI and the interlayer insulating layer IL. The second source and drain electrodes s2 and d2 respectively may contact the source area SA and the drain area DA of the first active pattern Act1 via a contact hole CNT2 formed in the gate insulating layer GI and the interlayer insulating layer IL.

Each of the first source and drain electrodes s1 and d1 may be formed as a single layer formed of at least one conductive material selected from Al, platinum (Pt), palladium (Pd), silver (Ag), magnesium (Mg), gold (Au), nickel (Ni), neodymium (Nd), iridium (Ir), chrome (Cr), lithium (Li), calcium (Ca), molybdenum (Mo), titanium (Ti), tungsten (W), and copper (Cu), or as multiple layers of the conductive material.

A portion of the first gate electrode g1 and a portion of the driving voltage line DVL are a first capacitor electrode C 1 and a second capacitor electrode C2, respectively. The first and second capacitor electrodes C 1 and C2, having the interlayer insulating layer IL disposed therebetween, may form the capacitor Cst. The first capacitor electrode C1 may be regarded as an upper electrode of the capacitor Cst, and the second capacitor electrode C2 may be regarded as a lower electrode of the capacitor Cst.

The planarizing layer PL may be disposed on the first source and drain electrodes s1 and d1. The planarizing layer PL may be disposed to cover the interlayer insulating layer IL and the conductive layer CL. The planarizing layer PL may be formed of, for example, an organic insulating material such as an acryl-based material or benzocyclobutene (BCB). The planarizing layer PL may function as a protection layer that may protect the driving and switching TFTs T 1 and T2, or as a planarizing layer that may planarize upper surfaces of the driving and switching TFTs T 1 and T2.

According to the present embodiment, a portion of the planarizing layer PL may be buried in the first dummy hole DH1. As described above, the planarizing layer PL may be formed of, for example, an organic insulating material, and the first dummy hole DH1 may not be electrically connected to any wiring or device of the TFT substrate structure 1.

Properties of the driving TFT T1 may be modified by the first dummy hole DH1 that may be located in the peripheral area of the driving TFT T1. For example, when annealing is performed, hydrogen ions in an interface of the first active pattern Act1 may quickly spread to the outside, for example, due to the first dummy hole DH1 formed in the peripheral area of the driving TFT T1. As a large amount of hydrogen ions spread to the outside, for example, due to the first dummy hole DH1, an interface trap density (Dit) value may increase, and mobility of the driving TFT T1 may be reduced. Accordingly, the properties of the driving TFT T1 may be modified. Regarding the description above, properties of a TFT may be easily modified according to a function of the TFT by adjusting a location and the number of the first dummy hole DH1.

A display device may be disposed on the TFT substrate structure 1. According to the present embodiment, the OLED may be disposed as the display device. The OLED may include the first electrode EL1, the second electrode EL2, and an intermediate layer that may include the emission layer EML that may be disposed between the first and second electrodes EL1 and EL2.

The first electrode EL1 of the OLED may be disposed on the planarizing layer PL. The first electrode EL1 may be a pixel electrode. The first electrode EL1 may be electrically connected to the first drain electrode d1 of the driving TFT T1 via a contact hole CNT3 formed in the planarizing layer PL.

The first electrode EL1 may be formed by using a high work function material. If the substrate 100 is a bottom emission type in which an image is displayed in a downward direction with respect to the substrate 100, the first electrode EL1 may be formed as a transparent conductive layer formed of indium tin oxide (ITO), indium zinc oxide (IZO), zinc oxide (ZnO), and indium tin zinc oxide (ITZO). According to an embodiment, if the substrate 100 is a top emission type in which an image is displayed in an upward direction with respect to the substrate 100, the first electrode EL1 may be formed as a metal reflection film formed of Ag, Mg, Al, Pt, Pd, Au, Ni, Nd, Ir, or Cr, or a transparent conductive layer formed of ITO, IZO, ZnO, or ITZO.

A pixel defining layer PDL that defines an emission area with respect to each pixel may be disposed on the substrate 100. The pixel defining layer PDL may be formed such that a boundary of a pixel may be covered and an upper surface of the first electrode EL1 may be exposed.

The emission layer EML may be provided on a portion of the first electrode EL1 which may be exposed by the pixel defining layer PDL, and the second electrode EL2 may be disposed on the emission layer EML.

According to embodiments of the invention, a lower common layer may be disposed between the first electrode EL1 and the emission layer EML, and an upper common layer may be disposed between the emission layer EML and the second electrode EL2. The lower common layer and the upper common layer function as carrier transport layers, and may be commonly stacked on each pixel. The lower common layer may include a hole injection layer (HIL) and a hole transport layer (HTL), and the upper common layer may include an electron injection layer (EIL) and an electron transport layer (ETL). According to the present embodiment, when the first electrode EL1 is a pixel electrode, the lower common layer, the upper common layer, and the emission layer EML may be stacked on the first electrode EL1 in the following order: the HIL, the HTL, the emission layer EML, the ETL, the EIL, and the second electrode EL2. In an embodiment, the lower common layer and the upper common layer may be modified.

The second electrode EL2 may be provided as a transparent electrode or a reflective electrode. When the second electrode EL2 is formed as a transparent electrode, the second electrode EL2 may include the above-described transparent conductive material. When the second electrode EL2 is formed as a reflective electrode, the second electrode EL2 may include a metal reflection film. The second electrode EL2 may be disposed on an entire surface of the substrate 100.

When the second electrode EL2 is formed as a (semi) transparent electrode, the second electrode EL2 may include a layer formed of a low work function metal, for example, one of Li, Ca, LiF/Ca, LiF/Al, Al, Ag, Mg, and a combination thereof, and a (semi) transparent conductive layer formed of one of ITO, IZO, ZnO, and In₂O₃. When the second electrode EL2 is formed as a reflective electrode, the second electrode EL2 may include a layer formed of one of Li, Ca, LiF/Ca, LiF/Al, Al, Ag, Mg, and a combination thereof. In an embodiment, a structure and a material of the second electrode EL2 may be modified in various ways.

An encapsulating layer may be formed on the second electrode EL2. The encapsulating layer may be formed by stacking a plurality of inorganic layers or alternately stacking an organic layer and an inorganic layer.

According to an embodiment of the invention, an encapsulating substrate may be disposed on the second electrode EL2. The substrate 100 may be sealed by the encapsulating substrate.

The plan view shown in FIG. 1 is only an example. The TFT substrate structure 1 may be modified according to designs.

FIG. 3 illustrates a schematic cross-sectional view of the TFT substrate structure 1 of FIG. 1. In FIG. 3, the TFT substrate structure 1 not only includes the first dummy hole DH1, but also the second dummy hole DH2. Referring to FIGS. 1 and 3, the TFT substrate structure 1 according to an embodiment may include the substrate 100, the TFT T1, and the insulating layer IL that may include the first and second dummy holes DH1 and DH2.

The buffer layer BFL may be disposed on the substrate 100, and the first active pattern Act1 may be disposed on the buffer layer BFL. The first active pattern Act1 may be formed of a semiconductor material and include amorphous silicon, polycrystalline silicon, or an organic semiconductor material. The first active pattern Act 1 may function as an active layer of the driving TFT T1. The first active pattern Act1 may include the source area SA, the drain area DA, and the channel area CA provided between the source and drain areas SA and DA. The source and drain areas SA and DA of the first active pattern Act1 may be doped with n-type or p-type impurities.

The gate insulating layer GI may be disposed on the first active pattern Act1. The gate insulating layer GI may be formed of, for example, silicon oxide and/or silicon nitride, and the first active pattern Act1 may be insulated from the first gate electrode g1.

According to the present embodiment of the invention, the gate insulating layer GI may have a multi-layer structure. As shown in FIG. 3, the gate insulating layer GI may include the first gate insulating layer GI1 and the second gate insulating layer GI2. The gate insulating layer GI may be formed as a multi-layer structure to prevent the gate insulating layer GI from being etched when patterning the first gate electrode g1.

The first gate insulating layer GI1 may be provided between the first active pattern Act1 and the first gate electrode g1, and may include silicon oxide. The second gate insulating layer GI2 may be provided between the first gate insulating layer GI1 and the first gate electrode g1, and may include silicon nitride. The second gate insulating layer GI2 may be formed above the first gate insulating layer GI1. The second gate insulating layer GI2 including silicon nitride may be relatively more resilient to an etching solution than the first gate insulating layer GI1 including silicon oxide, and the gate insulating layer GI may be less damaged when patterning the first gate electrode g1.

The first gate electrode g1 may be disposed on the gate insulating layer GI. The first gate electrode g1 may overlap at least one portion of the first active pattern Act1. The first gate electrode g1 may be disposed to cover an area of the second gate insulating layer GI2, which may correspond to the channel area CA of the first active pattern Act1. The first gate electrode g1 may be formed by using a metallic material with regard to conductivity. According to the present embodiment, the first gate electrode g1 may include Al. Al may provide a better manufacturing margin than other metallic materials, and Al may be useful for manufacturing a TFT substrate that may display a high-resolution image.

The insulating layer IL may be disposed on the first gate electrode g1 to cover the first gate electrode g1. The insulating layer IL may be referred to as the interlayer insulating layer IL. Such an interlayer insulating layer IL may be formed as a single layer or a plurality of layers of silicon oxide or silicon nitride.

The interlayer insulating layer IL may include at least one contact hole in which a conductive material is buried. A conductive material buried in the contact hole CNT1 may be regarded as a conductive layer CL that may form the first source electrode s1 and the first drain electrode d1 of the driving TFT T1. The first electrode EL1 of the OLED and the driving TFT T1 may be electrically connected to each other via the conductive material buried in the contact hole CNT1.

The interlayer insulating layer IL may include at least one first dummy hole DH1 in a peripheral area of the driving TFT T1. A location of the first dummy hole DH1 may not be limited to locations shown in FIGS. 1 and 3. Any number of first dummy holes DH1 maybe located anywhere in the peripheral area of the driving TFT T1. The first dummy hole DH1 may penetrate through the gate insulating layer GI and extend to an upper surface of the substrate.

According to the present embodiment, the interlayer insulating layer IL may include at least one second dummy hole DH2 that may be formed in an upper portion of the driving TFT T1. The second dummy hole DH2 may extend to an upper surface of the first gate electrode g1. A portion of the first gate electrode g1 may be exposed via the second dummy hole DH2. FIG. 3 illustrates that the second dummy hole DH2 may extend to the upper surface of the first gate electrode g1 and may be located on the first active pattern Act1. Referring to FIG. 1, the second dummy hole DH2 may actually be located in an upper portion of the first gate electrode g1, which may not overlap the first active pattern Act1.

A location of the second dummy hole DH2 may not be limited to FIGS. 1 and 3, and any number of second dummy holes DH2 may be located anywhere in the upper portion of the driving TFT T1. FIG. 1 illustrates that the first and second dummy holes DH1 and DH2 may be square-shaped. In an embodiment, respective shapes of the first and second dummy holes DH1 and DH2 may be circular, oval, or polygonal shaped.

Materials buried in the first and second dummy holes DH1 and DH2 may be different from a material of the interlayer insulating layer IL. The planarizing layer PL on the interlayer insulating layer IL may be buried in the first and second dummy holes DH1 and DH2. The first and second dummy holes DH1 and DH2 may not be electrically connected to any wiring or device in the TFT substrate structure 1. A width W2 of the second dummy hole DH2 may be substantially the same as the width W3 of the contact hole CNT 1.

The first source and drain electrodes s1 and d1, i.e., the conductive layer CL, may be disposed on the interlayer insulating layer IL. Referring to FIG. 1, the first source and drain electrodes s1 and d1 respectively may contact a source area and a drain area of the second active pattern Act2 via the contact hole CNT1 formed in the gate insulating layer GI and the interlayer insulating layer IL. The second source and drain electrodes s2 and d2 respectively may contact the source area SA and the drain area DA of the first active pattern Act1 via the contact hole CNT2 formed in the gate insulating layer GI and the interlayer insulating layer IL

Each of the first source and drain electrodes s1 and d1 may be formed as a single layer formed of at least one conductive material selected from Al, Pt, Pd, Ag, Mg, Au, Ni, Nd, Ir, Cr, Li, Ca, Mo, Ti, W, and Cu, or as multiple layers of the conductive material.

The planarizing layer PL may be disposed on the first source and drain electrodes s1 and d1. The planarizing layer PL may be disposed to cover the interlayer insulating layer IL and the conductive layer CL. The planarizing layer PL may be formed of, for example, an organic insulating material such as an acryl-based organic material or benzocyclobutene (BCB). The planarizing layer PL may function as a protection layer that may protect the driving and switching TFTs T 1 and T2, or as a planarizing layer that may planarize upper surfaces of the driving and switching TFTs T 1 and T2.

According to the present embodiment of the invention, a portion of the planarizing layer PL may be buried in the first dummy hole DH1. As described above, the planarizing layer PL may be formed of, for example, an organic insulating material, and the first and second dummy holes DH1 and DH2 may not be electrically connected to any wiring or device of the TFT substrate structure 1.

Properties of the driving TFT T1 may be adjusted by the first and second dummy holes DH1 and DH2 that are located in the peripheral area of the driving TFT T1. For example, when annealing is performed, hydrogen ions in an interface of the first active pattern Act1 may quickly spread to the outside, for example, due to the first and second dummy holes DH1 and DH2 formed in the peripheral area of the driving TFT T1. As a large amount of hydrogen ions spread to the outside, for example, due to the first and second dummy holes DH1 and DH2, an interface trap density (Dit) value may increase, and mobility of the driving TFT T1 may be reduced. Accordingly, the properties of the driving TFT T1 may be modified. Regarding the description above, properties of a TFT may be easily modified according to a function of the TFT by adjusting respective locations and numbers of the first and second dummy holes DH1 and DH2.

A display device may be disposed on the TFT substrate structure 1. According to the present embodiment, the OLED may be disposed as the display device. Details of the OLED are the same as that described above with reference to FIG. 2.

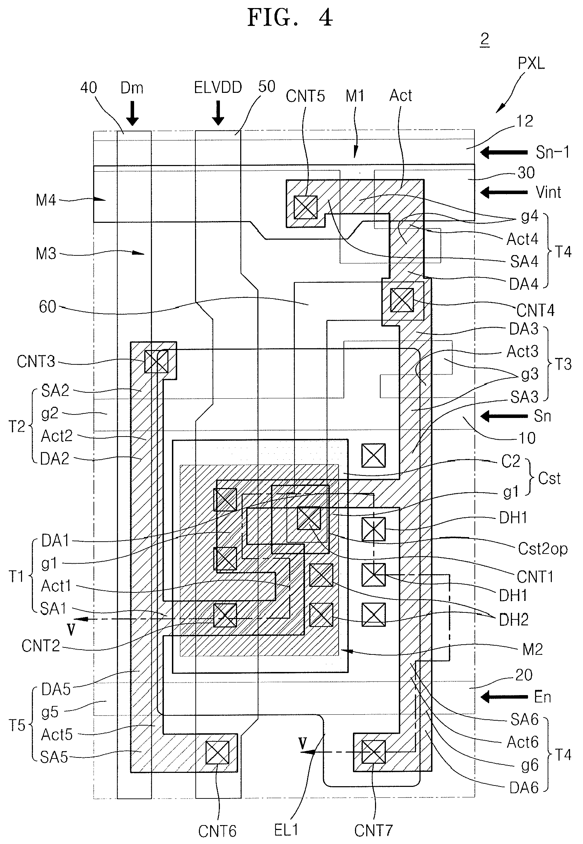

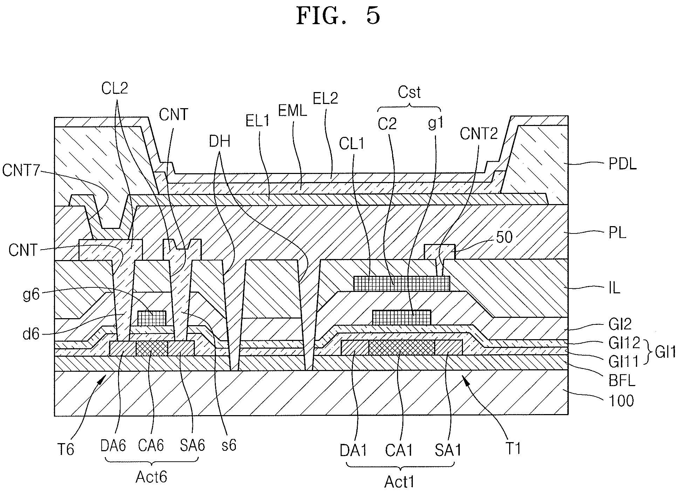

FIG. 4 illustrates a schematic plan view of a TFT substrate 2 according to an embodiment of the invention. FIG. 5 illustrates a schematic cross-sectional view of the TFT substrate 2 of FIG. 4 cut along a line IV-IV of FIG. 4.

Referring to FIGS. 4 and 5, the TFT substrate 2 according to this embodiment may include a substrate 100, a TFT T1, and an insulating layer IL that may include a dummy hole DH1.

The substrate 100 may be formed of various materials, for example, a glass material, a metallic material, or a plastic material such as PET, PEN, and polyimide. The substrate 100 may include a display area in which a plurality of pixels PXL are disposed, and a peripheral area that surrounds the display area.

At least one pixel PXL, which may display an image, may be provided on the substrate 100. When there is a plurality of pixels PXL, the pixels PXL may be arranged in a matrix form. Only one pixel PXL is illustrated in the present embodiment for convenience of description. In an embodiment, the pixel PXL may be rectangular-shaped, as shown in FIG. 1. In an embodiment, a shape of the pixel PXL may be modified in various ways. The pixels PXL may have different sizes. For example, the pixels PXL with different colors may have different sizes or shapes according to a color of each pixel PXL.

The pixel PXL may include a driving TFT T1, a switching TFT T2, a compensation TFT T3, an initialization TFT T4, an operation control TFT T5, an emission control TFT T6, a storage capacitor Cst, and an OLED.

The pixel PXL may include a scan line 10 to which a scan signal Sn may be applied, a previous scan line 12 to which a previous scan signal Sn-1 may be applied, an emission control line 20 to which an emission control signal En may be applied, an initialization voltage line 30 to which an initialization voltage Vint may be applied, a data line 40 to which a data signal Dm may be applied, and a driving voltage line 50 to which a driving voltage ELVDD may be applied. The scan line 10, the previous scan line 12, the emission control line 20, and the initialization voltage line 30 may extend in a row direction, whereas the data line 40 and the driving voltage line 50 may extend in a column direction.

The pixel PXL may include an active pattern Act, a first conductive layer M1, a second conductive layer M2, a third conductive layer M3, and a fourth conductive layer M4. Insulating layers may be provided among the active pattern Act, the first conductive layer M1, the second conductive layer M2, the third conductive layer M3, and the fourth conductive layer M4. The pixel PXL may include an intermediate layer that may include an emission layer, and a common electrode layer.

The active pattern Act may include respective active patterns (Act1 to Act6) of the driving TFT T1, the switching TFT T2, the compensation TFT T3, the initialization TFT T4, the operation control TFT T5, and the emission control TFT T6. The driving TFT T1, the switching TFT T2, the compensation TFT T3, the initialization TFT T4, the operation control TFT T5, and the emission control TFT T6 may be arranged along the active pattern Act.

FIG. 4 illustrates that the active pattern Act may be formed as a single pattern in the pixel PXL. In an embodiment, the active pattern Act may formed as two or more separated patterns according to designs. The active pattern Act may have various shapes according to designs, and include curved portions as shown in FIG. 4.

The first conductive layer M1 may include the previous scan line 12, the scan line 10, and the emission control line 20. The first conductive layer M1 may include respective gate electrodes (g1 to g6) of the driving TFT T1, the switching TFT T2, the compensation TFT T3, the initialization TFT T4, the operation control TFT T5, and the emission control TFT T6.

The second conductive layer M2 may include an upper electrode C2 of the storage capacitor Cst. The third conductive layer M3 may include the data line 40, the driving voltage line 50, and a connection line 60. The fourth conductive layer M4 may include the initialization voltage line 30 and a first electrode EL1.

The active pattern Act may be formed of polysilicon and include a channel area that may not be doped with impurities, a source area and a drain area that may be doped with impurities and formed at both sides of the channel area. A type of the impurities may vary according to a type of a TFT. The impurities may be an n-type or a p-type. The active pattern Act may include a driving active pattern Act1 of the driving TFT T1, a switching active pattern Act2 of the switching TFT T2, a compensation active pattern Act3 of the compensation TFT T3, an initialization active pattern Act4 of the initialization TFT T4, an operation control active pattern Act5 of the operation control TFT T5, and an emission control active pattern Act6 of the emission control TFT T6.

The driving TFT T1 may include the driving active pattern Act1 and a driving gate electrode g1. The driving active pattern Act1 may include a channel area CA1 that may overlap the driving gate electrode g1, and a source area SA1 and a drain area DA1. The source area SA1 and the drain area DA1 may not overlap the driving gate electrode g1 and the upper electrode C2. The driving active pattern Act1 may be curved.

The second conductive layer M2, which may include the upper electrode C2 of the capacitor Cst, may be disposed on the driving gate electrode g1. The upper electrode C2 may be disposed on the driving gate electrode g1. The upper electrode C2 in the capacitor Cst may overlap at least one portion of the driving gate electrode g1. The upper electrode C2 may include an opening Cst2op that may include a contact hole CNT1 formed between the driving gate electrode g1 and the connection line 60. In an embodiment, the opening Cst2op may be, for example, quadrilateral-shaped, as shown in FIG. 4. The upper electrode C2 may completely overlap the driving gate electrode g1 except for an area of the driving gate electrode g1 corresponding to the opening Cst2op, and capacitance may be maximized.

The upper electrode C2 and the driving gate electrode g1 may form the capacitor Cst. The driving gate electrode g1 may also function as a lower electrode of the capacitor Cst. The upper electrode C2 may be connected to the driving voltage line 50 via a contact hole CNT2.

At least one first dummy hole DH1 and at least one second dummy hole DH2 may be formed in an upper area or a peripheral area of the driving TFT T1. The first and second dummy holes DH1 and DH2 may be formed in the insulating layer IL, and according to embodiments, the first and second dummy holes DH1 and DH2 may extend to a layer under the insulating layer IL. The first and second dummy holes DH1 and DH2 may not be electrically connected to the driving TFT T1 as well as any nearby device or wiring, and a material buried in the first and second dummy holes DH1 and DH2 may be an insulating material that is different from a material used to form the insulating layer IL, where the first and second dummy holes DH1 and DH2 are located.

The switching TFT T2 may include the switching active pattern Act2, and a switching gate electrode g2 that may be a portion of the scan line 10. The switching active pattern Act2 may include a channel area that may overlap the switching gate electrode g2, and a source area SA2 and a drain area DA2 at both sides of the channel area. The source area SA2 may be connected to the data line 40 via a contact hole CNT3. The drain area DA2 may be connected to the source area SA1 of the driving TFT T1 along the active pattern Act.

The compensation TFT T3 may include the compensation active pattern Act3, and a compensation gate electrode g3 that may be a portion of the scan line 10. The compensation active pattern Act3 may include a channel area that may overlap the compensation gate electrode g3 and a source area SA3 and a drain area DA3 at both sides of the channel area. The source area SA3 may be connected to the drain area DA1 of the driving TFT T1 along the active pattern Act. The drain area DA3 may be connected to the connection line 60 via a contact hole CNT4. The drain area DA3 of the compensation TFT T3 may be electrically connected to the driving gate electrode g1 via the connection line 60. As shown in FIG. 4, the compensation gate electrode g3 may be formed as a separate dual gate electrode, and current leakage may be prevented.

The initialization TFT T4 may include the initialization active pattern Act4, and an initialization gate electrode g4 that may be a portion of the previous scan line 12. The initialization active pattern Act4 may include a channel area that may overlap the initialization gate electrode g4, and a source area SA4 and a drain area DA4 at both sides of the channel area. The source area SA4 may be connected to the initialization voltage line 30 via a contact hole CNT5. The contact hole CNT5 may include a connecting unit formed by using the third conductive layer M3, a contact hole that may connect the connecting unit and the source area SA4, and another contact hole that may connect the connecting unit and the initialization voltage line 30. The drain area DA4 may be connected to the connection line 60 via the contact hole CNT4. As shown in FIG. 4, the initialization gate electrode g4 may be formed as a separate dual gate electrode.

The operation control TFT T5 may include the operation control active pattern Act5, and an operation control gate electrode g5 that may be a portion of the emission control line 20. The operation control active pattern Act5 may include a channel area that may overlap the operation control gate electrode g5, and a source area SA5 and a drain area DA5 at both sides of the channel area. The drain area DA5 may be connected to the source area SA1 of the driving TFT T1 along the active pattern Act. The source area SA5 may be connected to the driving voltage line 50 via a contact hole CNT6.

The emission control TFT T6 may include the emission control active pattern Act6, and an emission control gate electrode g6 that may be a portion of the emission control line 20. The emission control active pattern Act6 may include a channel area that may overlap the emission control gate electrode g6, and a source area SA6 and a drain area DA6 at both sides of the channel area. The source area SA6 may be connected to the drain area DA1 of the driving TFT T1 along the active pattern Act. The drain area DA6 may be connected to the first electrode EL1 via a contact hole CNT7. The contact hole CNT7 may include a connecting unit formed by using the third conductive layer M3, a contact hole that may connect the connecting unit and the drain area DA4, and another contact hole that may connect the connecting unit and the first electrode EL1.

The first electrode EL1 may be disposed on the upper electrode C2, and supply current to an intermediate layer that may include an organic emission layer and disposed on the first electrode EL1. The current applied to the intermediate layer may be transmitted to a common electrode on the intermediate layer.

The plan view shown in FIG. 4 is only an example. The TFT substrate 2 may be modified according to designs.

Hereinafter, referring to FIG. 5, the TFT substrate 2 according to an embodiment of the invention will be described according to a stacking order.

Referring to FIG. 5, the TFT substrate 2 according to an embodiment may include the driving TFT T1, the switching TFT T2, the compensation TFT T3, the initialization TFT T4, the operation control TFT T5, the emission control TFT T6, and the substrate 100 that may be insulative and on which the storage capacitor Cst may be stacked. A liquid device and an OLED may be disposed on the substrate 100. According to the present embodiment, an example in which an OLED may be disposed on the substrate 100 is described.

A buffer layer BFL may be disposed on the substrate 100. The buffer layer BFL may planarize an upper surface of the substrate 100 or block impurities from spreading in the driving TFT T1, the switching TFT T2, the compensation TFT T3, the initialization TFT T4, the operation control TFT T5, the emission control TFT T6. The buffer layer BFL may be formed of, for example, silicon nitride, silicon oxide, or silicon oxynitride. The buffer layer BFL may be omitted according to a material of the substrate 100 and manufacturing conditions.

The driving TFT T 1 and the emission control TFT T6 may be disposed on the buffer layer BFL. The upper electrode C2 may be disposed on the driving TFT T1, and the driving gate electrode g1 and the upper electrode C2 may form the storage capacitor Cst.

A lower gate insulating layer GI1 may be disposed between the driving and emission control active patterns Act1 and Act6 and the driving and emission control gate electrodes g1 and g6, and the driving and emission control active patterns Act1 and Act6 may be insulated from the driving and emission control gate electrodes g1 and g6. An upper gate insulating layer GI2 may be disposed between the driving gate electrode g1 and the upper electrode C2, and the driving gate electrode g1 may be insulated from the upper electrode C2. The upper gate insulating layer GI2 may be a dielectric layer between the driving gate electrode g1 and the upper electrode C2. The driving TFT T1, the storage capacitor Cst, and the emission control TFT T6 may be covered by the insulating layer IL.

According to the present embodiment of the invention, the lower gate insulating layer GI1 may have a multi-layer structure. As shown in FIG. 5, the lower gate insulating layer GI1 may include a first gate insulating layer GI11 and a second gate insulating layer GI12. The lower gate insulating layer GI1 may be formed as a multi-layer structure to prevent the lower gate insulating layer GI1 from being etched when patterning the first gate electrode g1.

The first gate insulating layer GI11 may include silicon oxide, and the second gate insulating layer GI12 may include silicon nitride. The second gate insulating layer GI12 may be formed above the first gate insulating layer GI11. The second gate insulating layer GI12 including silicon nitride may be relatively more resilient to an etching solution than the first gate insulating layer GI11 including silicon oxide, and the lower gate insulating layer GI1 may be less damaged when patterning the first gate electrode g1.

The upper gate insulating layer GI2 or the interlayer insulating layer IL may also have a multi-layer structure, and may be formed of, for example, silicon oxide and/or silicon nitride.

According to the present embodiment of the invention, the driving gate electrode g1 may be formed by using a metallic material with regard to conductivity. According to the present embodiment, the driving gate electrode g1 may include Al. Al may provide a better manufacturing margin than other metallic materials, and Al may be useful for manufacturing a TFT substrate that may display a high-resolution image.

A first conductive layer CL1 that may include the upper electrode C2 of the storage capacitor Cst may be disposed on the second gate insulating layer GI12. The first conductive layer CL1 of FIG. 5 may be regarded as the second conductive layer M2 of FIG. 4. The upper electrode C2 may overlap at least one portion of the driving gate electrode g1. The driving gate electrode g1 may be used as a lower electrode, and the driving gate electrode g1 and the upper electrode C2 may form the storage capacitor Cst.

The insulating layer IL may be disposed on the upper electrode C2 of the storage capacitor Cst to cover the upper electrode C2 of the storage capacitor Cst. The insulating layer IL may be referred to as an interlayer insulating layer IL. The interlayer insulating layer IL may be formed as a single layer or a plurality of layers of silicon oxide or silicon nitride.

The contact hole CNT2, which exposes a portion of the upper electrode C2 of the storage capacitor Cst, may be formed in the interlayer insulating layer IL. A contact hole CNT, which exposes the source and drain areas SA6 and DA6 of the emission control active pattern Act6 of the emission control TFT T6, may be formed in the interlayer insulating layer IL. The contact hole CNT may penetrate through the upper gate insulating layer GI2 and the lower gate insulating layer GI1 and extend to an upper portion of the emission control active pattern Act6. The emission control TFT T6 may be electrically connected to the first electrode EL1 of the OLED via the contact hole CNT.

A power line 50 that applies a power voltage to the upper electrode C2 of the storage capacitor Cst, and a second conductive layer CL2 that may include a source electrode s6 and a drain electrode d6of the emission control TFT T6 may be disposed on the interlayer insulating layer IL. The second conductive layer CL2 of FIG. 5 may be regarded as the third conductive layer M3 of FIG. 4. The upper electrode C2 of the storage capacitor Cst may be electrically connected to the power line 50 via a conductive material buried in the contact hole CNT2. The power line 50 may be regarded as the driving voltage line 50. The contact hole CNT2 may be modified in various ways. For example, the contact hole CNT2 may be more than one hole.

The drain area DA6 of the emission control TFT T6 may be electrically connected to the drain electrode d6 via the contact hole CNT that may penetrate through the lower gate insulating layer GI1, the upper gate insulating layer GI2, and the interlayer insulating layer IL. The source area SA6 of the emission control TFT T6 may be electrically connected to the source electrode s6 via the contact hole CNT that may penetrate through the lower gate insulating layer GI1, the upper gate insulating layer GI2, and the interlayer insulating layer IL.

The driving voltage line 50 and the second conductive layer CL2 that may include the source and drain electrodes s6 and d6 may be formed as a single layer formed of at least one conductive material selected from, for example, Al, Pt, Pd, Ag, Mg, Au, Ni, Nd, Ir, Cr, Li, Ca, Mo, Ti, W, and Cu, or multiple layers of the conductive material.

The interlayer insulating layer IL may include at least one first dummy hole DH1 in a peripheral area of the driving TFT T1. The first dummy hole DH1 may penetrate through the upper gate insulating layer GI2 (which may be a dielectric layer) and the lower gate insulating layer GI1, and extend to an upper surface of the substrate 100. FIG. 1 illustrates that the first dummy hole DH1 may be square-shaped. In an embodiment, the first dummy hole DH1 may be circular, oval, or polygonal shaped. A location of the first dummy hole DH1 may not be limited to locations shown in FIGS. 4 and 5. Any number of first dummy holes DH1 may be located anywhere in the peripheral area of the driving TFT T1.

According to the present embodiment of the invention, a material buried in the first dummy hole DH1 may be different from a material of the interlayer insulating layer IL. A planarizing layer PL on the interlayer insulating layer IL may be buried in the first dummy hole DH1. The first dummy hole DH1 may not be electrically connected to any wiring or device in the TFT substrate 2. A width W1 of the first dummy hole DH1 may be substantially the same as a width W3 of the contact hole CNT1.

The planarizing layer PL may be disposed to cover the source electrode s6, the drain electrode d6, and the driving voltage line 50 on the interlayer insulating layer IL. The planarizing layer PL may be formed of, for example, an inorganic insulating material including an oxide, a nitride, and/or an oxynitride, or an organic insulating material such as an acryl-based material or BCB. The planarizing layer PL may function as a protection layer that may protect the driving TFT T1, the switching TFT T2, the compensation TFT T3, the initialization TFT T4, the operation control TFT T5, and the emission control TFT T6, or may planarize upper surfaces of the driving TFT T1, the switching TFT T2, the compensation TFT T3, the initialization TFT T4, the operation control TFT T5, and the emission control TFT T6.

Properties of the driving TFT T1 may be adjusted by using the first dummy hole DH1 in the peripheral area of the driving TFT T1. For example, when annealing is performed, hydrogen ions in an interface of the driving active pattern Act1 may quickly spread to the outside, for example, due to the first dummy hole DH1 formed in the peripheral area of the driving TFT T1. As a large amount of hydrogen ions spread to the outside, for example, due to the first dummy hole DH1, an interface trap density (Dit) value may increase, and mobility of the driving TFT T1 may be reduced. Accordingly, the properties of the driving TFT T1 may be modified. Regarding the description above, properties of a TFT may be easily modified according to a function of the TFT by adjusting a location and the number of the first dummy hole DH1.

A display device may be disposed on the TFT substrate 2. According to the present embodiment, the OLED may be disposed as the display device. The OLED may include the first electrode EL1, a second electrode EL2, and an intermediate layer that may include an emission layer EML that may be disposed between the first and second electrodes EL1 and EL2.

The first electrode EL1 of the OLED may be disposed on the planarizing layer PL. The first electrode EL1 may be a pixel electrode. The first electrode EL1 may be electrically connected to the drain electrode d6 of the emission control TFT T6 via a contact hole CNT7 formed in the planarizing layer PL.

The first electrode EL1 may be formed by using a high work function material. If the substrate 100 is a bottom emission type in which an image is displayed in a downward direction with respect to the substrate 100, the first electrode EL1 may be formed as a transparent conductive layer formed of ITO, IZO, ZnO, and ITZO. According to an embodiment, if the substrate 100 is a top emission type in which an image is displayed in an upward direction with respect to the substrate 100, the first electrode EL1 may be formed as a metal reflection film formed of Ag, Mg, Al, Pt, Pd, Au, Ni, Nd, Ir, or Cr, or a transparent conductive layer formed of ITO, IZO, ZnO, or ITZO.

A pixel defining layer PDL that defines an emission area with respect to each pixel may be disposed on the substrate 100. The pixel defining layer PDL may be formed such that a boundary of a pixel may be covered and an upper surface of the first electrode EL1 may be exposed.

The emission layer EML may be provided on a portion of the first electrode EL1 which may be exposed by the pixel defining layer PDL, and the second electrode EL2 may be disposed on the emission layer EML.

The emission layer EML may emit one selected from red light, green light, and blue light. According to an embodiment of the invention, the emission layer EML may emit white light, and a display apparatus may additionally include red, green, and blue color filter layers to output images with various colors.

According to embodiments of the invention, a lower common layer may be disposed between the first electrode EL1 and the emission layer EML, and an upper common layer may be disposed between the emission layer EML and the second electrode EL2. The lower common layer and the upper common layer function as carrier transport layers, and may be commonly stacked on each pixel. The lower common layer may include an HIL and an HTL, and the upper common layer may include an EIL and an ETL. According to the present embodiment, when he first electrode EL1 is a pixel electrode, the lower common layer, the upper common layer, and the emission layer EML may be stacked on the first electrode EL1 in the following order: the HIL, the HTL, the emission layer EML, the ETL, the EIL, and the second electrode EL2. In an embodiment, the lower common layer and the upper common layer may be modified.

The second electrode EL2 may be stacked over an entire surface of the substrate 100. The second electrode EL2 may be a transparent electrode or a reflective electrode. When the second electrode EL2 is used as a transparent electrode, the second electrode EL2 may include a first layer formed of one of ITO, IZO, ZnO, and In₂O₃, and a combination thereof, and a second layer that may be formed on the first layer and may include one of Li, Ca, LiF/Ca, LiF/Al, Al, Mg. The second layer may be formed as an auxiliary electrode or a bus electrode line. When the second electrode EL2 is used as a reflective electrode, one of Li, Ca, LiF/Ca, LiF/Al, Al, Mg, and a combination thereof is deposited on an entire surface of the substrate 100.

An encapsulating layer may be formed on the second electrode EL2. The encapsulating layer may be formed by stacking a plurality of inorganic layers or alternately stacking an organic layer and an inorganic layer.

According to an embodiment of the invention, an encapsulating substrate may be disposed on the second electrode EL2. The substrate 100 may be sealed by the encapsulating substrate.

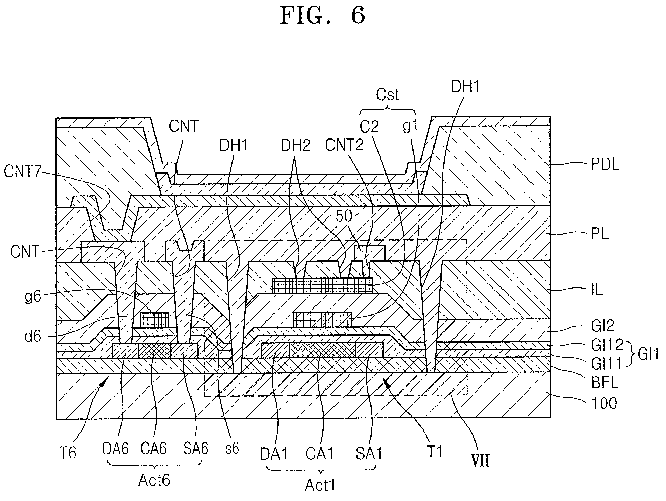

FIG. 6 illustrates a schematic cross-sectional view of the TFT substrate of FIG. 4. In FIG. 6, the TFT substrate 2 not only includes the first dummy hole DH1, but also the second dummy hole DH2. Referring to FIGS. 4 and 6, the TFT substrate 2 according to an embodiment may include the substrate 100, the driving TFT T1, the switching TFT T2, the compensation TFT T3, the initialization TFT T4, the operation control TFT T5, and the emission control TFT T6, and the insulating layer IL that may include the first and second dummy holes DH1 and DH2.

The buffer layer BFL may be disposed on the substrate 100. The driving TFT T1 and the emission control TFT T6 may be disposed on the buffer layer BFL. The upper electrode C2 may be disposed on the driving TFT T1, and the driving gate electrode g1 and the upper electrode C2 may form the capacitor Cst.

The lower gate insulating layer GI1 may be disposed between the driving and emission control active patterns Act1 and Act6 and the driving and emission control gate electrodes g1 and g6, and the driving and emission control active patterns Act1 and Act6 may be insulated from the driving and emission control gate electrodes g1 and g6. The upper gate insulating layer GI2 may be disposed between the driving gate electrode g1 and the upper electrode C2, and the driving gate electrode g1 may be insulated from the upper electrode C2. The upper gate insulating layer GI2 may be a dielectric layer between the driving gate electrode g1 and the upper electrode C2. The driving TFT T1, the capacitor Cst, and the emission control TFT T6 may be covered by the interlayer insulating layer IL.

According to the present embodiment, the lower gate insulating layer GI1 may have a multi-layer structure. As shown in FIG. 6, the lower gate insulating layer GI1 may include the first gate insulating layer GI11 and the second gate insulating layer GI12. The lower gate insulating layer GI1 may be formed as a multi-layer structure to prevent the lower gate insulating layer GI1 from being etched when patterning the first gate electrode g1.

The first gate insulating layer GI1 may include silicon oxide, and the second gate insulating layer GI2 may include silicon nitride. The second gate insulating layer GI12 may be formed above the first gate insulating layer GI11. The second gate insulating layer GI12 including silicon nitride may be relatively more resilient to an etching solution than the first gate insulating layer GI11 including silicon oxide, and the lower gate insulating layer GI1 may be less damaged when patterning the first gate electrode g1.

The upper gate insulating layer GI2 or the interlayer insulating layer IL may also have a multi-layer structure, and may be formed of, for example, silicon oxide and/or silicon nitride.

According to the present embodiment, the driving gate electrode g1 may be formed by using a metallic material with regard to conductivity. According to the present embodiment, the driving gate electrode g1 may include Al. Al may provide a better manufacturing margin than other metallic materials, and Al may be useful for manufacturing a TFT substrate that may display a high-resolution image.

The power line 50 that applies a power voltage to the upper electrode C2 of the storage capacitor Cst, and the second conductive layer CL2 that may include the source electrode s6 and the drain electrode d6 of the emission control TFT T6 may be disposed on the interlayer insulating layer IL. The second conductive layer CL2 of FIG. 6 may be regarded as the third conductive layer M3 of FIG. 4. The upper electrode C2 of the capacitor Cst may be electrically connected to the power line 50 via a conductive material buried in the contact hole CNT2. The power line 50 may be regarded as the driving voltage line 50. The contact hole CNT2 may be modified in various ways. For example, the contact hole CNT2 may be more than one hole.

The drain area DA6 of the emission control TFT T6 may be electrically connected to the drain electrode d6 via the contact hole CNT that may penetrate through the lower gate insulating layer GI1, the upper gate insulating layer GI2, and the interlayer insulating layer IL. The source area SA6 of the emission control TFT T6 may be electrically connected to the source electrode s6 via the contact hole CNT that may penetrate through the lower gate insulating layer GI1, the upper gate insulating layer GI2, and the interlayer insulating layer IL.

The driving voltage line 50 and the second conductive layer CL2 that may include the source and drain electrodes s6 and d6 may be formed as a single layer formed of at least one conductive material selected from, for example, Al, Pt, Pd, Ag, Mg, Au, Ni, Nd, Ir, Cr, Li, Ca, Mo, Ti, W, and Cu, or multiple layers of the conductive material.

The interlayer insulating layer IL may include at least one first dummy hole DH1 in a peripheral area of the driving TFT T1. The first dummy hole DH1 may penetrate through the upper gate insulating layer GI2 (which may be a dielectric layer) and the lower gate insulating layer GI1, and extend to an upper surface of the substrate 100.

According to the present embodiment, the interlayer insulating layer IL may include at least one second dummy hole DH2 that may be formed in an upper portion of the driving TFT T1. The second dummy hole DH2 may extend to an upper surface of the upper electrode C2. A portion of the upper electrode C2 may be exposed via the second dummy hole DH2. FIG. 6 illustrates that the second dummy hole DH2 may extend to the upper surface of the upper electrode C2 and may be located on the driving active pattern Act1. Referring to FIG. 4, the second dummy hole DH2 may actually be located in an upper portion of the upper electrode C2 which may not overlap the driving active pattern Act1.

FIG. 1 illustrates that the first and second dummy holes DH1 and DH2 may be square-shaped. In an embodiment, the first and second dummy holes DH1 and DH2 may be circular, oval, or polygonal shaped. Respective locations of the first and second dummy holes DH1 and DH2 are not limited to locations shown in FIGS. 4 and 6. Any number of the first and second dummy holes DH1 and DH2 may be located anywhere in the peripheral area of the driving TFT T1.

According to the present embodiment, materials buried in the first and second dummy holes DH1 and DH2 may be different from a material of the interlayer insulating layer IL. The planarizing layer PL on the interlayer insulating layer IL may be buried in the first and second dummy holes DH1 and DH2. The first and second dummy holes DH1 and DH2 may not be electrically connected to any wiring or device in the TFT substrate 2. The width W1 of the first dummy hole DH1 and a width W2 of the second dummy hole DH2 may be substantially the same as the width W3 of the contact hole CNT1.

The planarizing layer PL may be disposed to cover the source electrode s6, the drain electrode d6, and the driving voltage line 50 on the interlayer insulating layer IL. The planarizing layer PL may be formed of, for example, an inorganic insulating material including an oxide, a nitride, and/or an oxynitride, or an organic insulating material such as an acryl-based material or BCB. The planarizing layer PL may function as a protection layer that may protect the driving TFT T1, the switching TFT T2, the compensation TFT T3, the initialization TFT T4, the operation control TFT T5, and the emission control TFT T6, or may planarize upper surfaces of the driving TFT T1, the switching TFT T2, the compensation TFT T3, the initialization TFT T4, the operation control TFT T5, and the emission control TFT T6.

Properties of the driving TFT T1 may be adjusted by using the first and second dummy holes DH1 and DH2 in the peripheral area of the driving TFT T1. For example, when annealing is performed, hydrogen ions in an interface of the driving active pattern Act1 may quickly spread to the outside, for example, due to the first and second dummy holes DH1 and DH2 formed in the peripheral area of the driving TFT T1. As a large amount of hydrogen ions spread to the outside, for example, due to the first and second dummy holes DH1 and DH2, an interface trap density (Dit) value may increase, and mobility of the driving TFT T1 may be reduced. Accordingly, the properties of the driving TFT T1 may be modified. Regarding the description above, properties of a TFT may be easily modified according to a function of the TFT by adjusting respective locations and numbers of the first and second dummy holes DH1 and DH2.

A display device may be disposed on the TFT substrate 2. According to the present embodiment, the OLED may be disposed as the display device. Details of the OLED are the same as that described above with reference to FIG. 5.

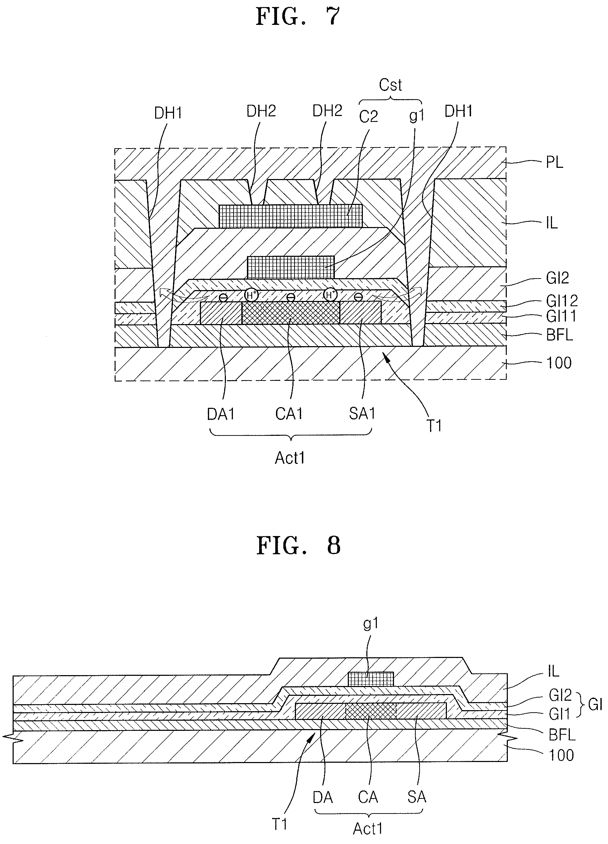

FIG. 7 illustrates a conceptual view of a portion VII of FIG. 6.

Referring to FIG. 7, during a manufacturing process of the TFT substrate 2 according to the present embodiment, the interlayer insulating layer IL may be patterned to form the contact hole CNT and the first and second dummy holes DH1 and DH2, and then, the interlayer insulating layer IL may be annealed. The interlayer insulating layer IL may be annealed in, for example, about 300°C to about 400°C for about 1 hour or less. During such processing, hydrogen ions in the interlayer insulating layer IL easily spread to the outside via the first and second dummy holes DH1 and DH2.

When annealing is performed, hydrogen ions in an interface of the driving active pattern Act1 may quickly spread to the outside, for example, due to the first and second dummy holes DH1 and DH2 formed in the peripheral area of the driving TFT T1. As a large amount of hydrogen ions spread to the outside, for example, due to the first and second dummy holes DH1 and DH2, an interface trap density (Dit) value may increase, and mobility of the driving TFT T1 may be reduced. Accordingly, the properties of the driving TFT T1 may be modified. Regarding the description above, properties of a TFT may be easily modified according to a function of the TFT by adjusting respective locations and numbers of the first and second dummy holes DH1 and DH2.

FIGS. 8 to 12 illustrate schematic cross-sectional views of a method of manufacturing the TFT substrate structure 1 of FIG. 1.

Referring to FIG. 8, the driving TFT T1 may be formed on the substrate 100.

The substrate 100 may be formed of various materials, for example, a glass material, a metallic material, or a plastic material such as PET, PEN, and polyimide. The buffer layer BFL may be formed on the substrate 100. The buffer layer BFL may planarize an upper surface of the substrate 100 or block impurities from spreading in the driving TFT T1. The buffer layer BFL may be formed of, for example, silicon nitride, silicon oxide, or silicon oxynitride. The buffer layer BFL may be omitted according to a material of the substrate 100 and manufacturing conditions.

The first active pattern Act1 may be formed on the buffer layer BFL. The first active pattern Act1 may be formed of a semiconductor material and function as an active layer of the driving TFT T1. The source area SA, the drain area DA, and the channel area CA provided between the source and drain areas SA and DA may be formed by doping the source and drain areas SA and DA of the first active pattern Act1 with n-type or p-type impurities.

The gate insulating layer GI may be formed on the first active pattern Act1. The gate insulating layer GI may be formed of, for example, silicon oxide and/or silicon nitride, and the first active pattern Act1 may be insulated from the first gate electrode g1.

According to the present embodiment of the invention, the gate insulating layer GI may have a multi-layer structure. As shown in FIG. 8, the gate insulating layer GI may include the first gate insulating layer GI1 and the second gate insulating layer GI2. The gate insulating layer GI may be formed as a multi-layer structure to prevent the gate insulating layer GI from being etched when patterning the first gate electrode g1.

The first gate insulating layer GI1 may be formed on the first active pattern Act1 and second gate insulating layer GI2 may be formed on the first gate insulating layer GI1. The first gate insulating layer GI1 may be formed of, for example, silicon oxide. The second gate insulating layer GI2 may be formed of, for example, silicon nitride. The second gate insulating layer GI2 may be formed above the first gate insulating layer GI1. The second gate insulating layer GI2 including silicon nitride may be relatively more resilient to an etching solution than the first gate insulating layer GI1 including silicon oxide, and the gate insulating layer GI may be less damaged when patterning the first gate electrode g1.

The first gate electrode g1 may be formed on the second gate insulating layer GI2 such that the first gate electrode g1 may overlap at least one portion of the first active pattern Act1. An area of the second gate insulating layer GI2 in which the first gate electrode g1 may overlap the first active pattern Act1 may function as the channel area CA. The first gate electrode g1 may be formed by using a metallic material with regard to conductivity. According to the present embodiment, the first gate electrode g1 may include Al. Al may provide a better manufacturing margin than other metallic materials, and Al may be useful for manufacturing a TFT substrate that may display a high-resolution image.

The insulating layer IL may be formed on the first gate electrode g1 to cover the first gate electrode g1. The insulating layer IL may be referred to as an interlayer insulating layer IL. Such an interlayer insulating layer IL may be formed as a single layer or multiple layers of silicon oxide or silicon nitride.

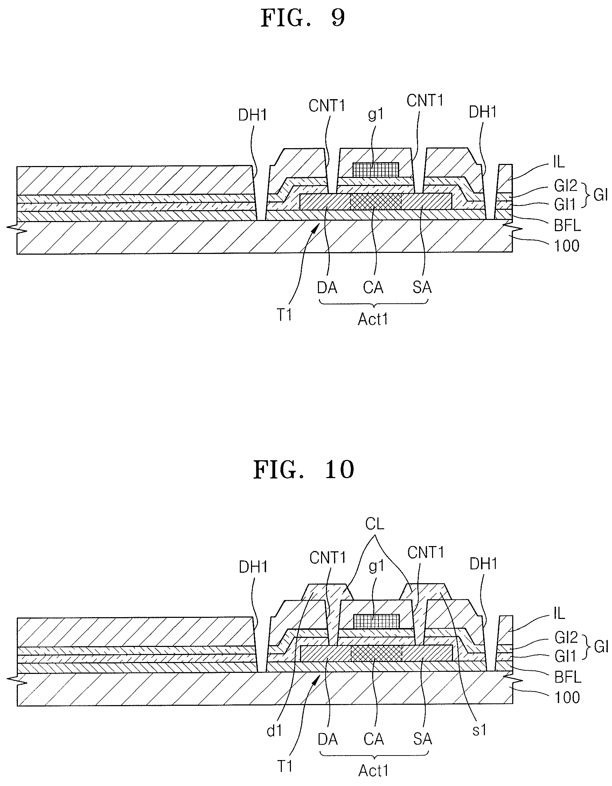

Referring to FIG. 9, a manufacturing process of the interlayer insulating layer IL may include coating an insulating material on the substrate 100, patterning the insulating material, and forming the first and second dummy holes DH1 and DH2 in peripheral areas or upper areas of the contact hole CNT1 and the TFT T1. The contact hole CNT1 1 and the first and second dummy holes DH1 and DH2 may be simultaneously formed by using the same mask, and have substantially the same width. The contact hole CNT1 may be patterned such that the source and drain areas SA and DA of the first active pattern Act1 are exposed. The first dummy hole DH1 may be patterned such that the first dummy hole DH1 may penetrate through the gate insulating layer GI and may extend to an upper surface of the substrate 100. The second dummy hole DH2 may extend to an upper surface of the first gate electrode g1, and a portion of an upper surface of the first gate electrode g1 may be exposed.

FIG. 9 illustrates that two first dummy holes DH1 and two second dummy holes DH2 may be formed in the interlayer insulating layer IL, respective locations and numbers of the first and second dummy holes DH 1 and DH2 may be modified. The first and second dummy holes DH1 and DH2 may have various shapes, for example, circular, oval, or polygonal shapes. The interlayer insulating layer IL may be formed of an inorganic insulating material, for example, silicon oxide or silicon nitride.

Referring to FIG. 10, the conductive layer CL may be formed on the interlayer insulating layer IL in which the contact hole CNT 1 and the first and second dummy holes DH1 and DH2 may be formed. The conductive layer CL may be patterned such that a portion of the conductive layer CL is buried in the contact hole CNT1. The first source and drain electrodes s1 and s2 may respectively contact the source and drain areas SA and DA of the first active pattern Act1 via the conductive layer CL buried in the contact hole CNT1. The first electrode EL1 of the OLED and the driving TFT T1 maybe electrically connected to each other via a conductive material buried in the contact hole CNT1. With regard to the conductivity of the first source and drain electrodes s1 and d1, the conductive layer CL may be formed as a single layer formed of at least one conductive material selected from Al, Pt, Pd, Ag, Mg, Au, Ni, Nd, Ir, Cr, Li, Ca, Mo, Ti, W, and Cu, or as multiple layers of the conductive material.

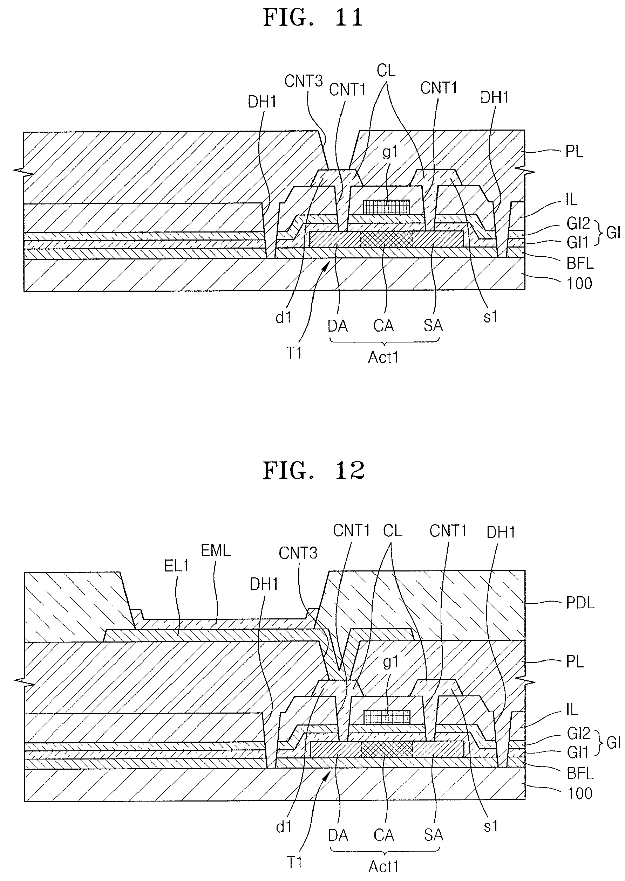

Referring to FIG. 11, the planarizing layer PL may be formed to cover the interlayer insulating layer IL and the conductive layer CL. A portion of the planarizing layer PL may be buried in the first and second dummy holes DH1 and DH2. The planarizing layer PL may be formed of an organic insulating material, for example, an acryl-based organic material or BCB. An insulating material buried in the first and second dummy holes DH1 and DH2 may be different from a material of the interlayer insulating layer IL, where the first and second dummy holes DH1 and DH2 are located. The first and second dummy holes DH1 and DH2 may not be electrically connected to any wiring or device in the TFT substrate structure 1.

Properties of the driving TFT T1 may be adjusted by using the first and second dummy holes DH1 and DH2 in the peripheral area of the driving TFT T1. For example, hydrogen ions exist in an interface of the first active pattern Act1, and when annealing is performed, hydrogen ions in an interface of the first active pattern Act1 may quickly spread to the outside, for example, due to the first and second dummy holes DH1 and DH2 formed in the peripheral area of the driving TFT T1. As a large amount of hydrogen ions spread to the outside, for example, due to the first and second dummy holes DH1 and DH2, an interface trap density (Dit) value may increase, and mobility of the driving TFT T1 may be reduced. Accordingly, the properties of the driving TFT T1 may be modified. Regarding the description above, properties of a TFT may be easily modified according to a function of the TFT by adjusting respective locations and numbers of the first and second dummy holes DH1 and DH2.

Referring FIG. 12, a display device may be formed on the TFT substrate structure 1. According to the present embodiment, the OLED may be disposed as the display device.

The first electrode EL1 of the OLED may be formed on the planarizing layer PL. The first electrode EL1 may be a pixel electrode. The first electrode EL1 may be electrically connected to the first drain electrode d1 of the driving TFT T1 via the contact hole CNT3 formed in the planarizing layer PL.

The first electrode EL1 may be formed by using a high work function material. If the substrate 100 is a bottom emission type in which an image is displayed in a downward direction with respect to the substrate 100, the first electrode EL1 may be formed as a transparent conductive layer formed of ITO, IZO, ZnO, and ITZO. According to an embodiment, if the substrate 100 is a top emission type in which an image is displayed in an upward direction with respect to the substrate 100, the first electrode EL1 may be formed as a metal reflection film formed of Ag, Mg, Al, Pt, Pd, Au, Ni, Nd, Ir, or Cr, or a transparent conductive layer formed of ITO, IZO, ZnO, or ITZO.

A pixel defining layer PDL that defines an emission area with respect to each pixel may be formed on the substrate 100. The pixel defining layer PDL may be formed such that a boundary of a pixel may be covered and an upper surface of the first electrode EL1 may be exposed.

The emission layer EML may be formed on a portion of the first electrode EL1 which may be exposed by the pixel defining layer PDL. According to embodiments of the invention, the lower common layer including the HIL and HTL may be formed between the first electrode EL1 and the emission layer EML, and the upper common layer including the EIL and the ETL may be formed between the emission layer EML and the second electrode EL2. In an embodiment, the lower common layer and the upper common layer may be modified.

After the processes above, the second electrode EL2 may be formed over an entire surface of the substrate 100. The second electrode EL2 may be an opposite electrode that is facing a pixel electrode, or a common electrode. The second electrode EL2 may also be formed as a transparent electrode or a reflective electrode. When the second electrode EL2 is formed as a (semi) transparent electrode, the second electrode EL2 may include a layer formed of a low work function metal, for example, one of Li, Ca, LiF/Ca, LiF/Al, Al, Ag, Mg, and a combination thereof, and a (semi) transparent conductive layer formed of one of ITO, IZO, ZnO, and In₂O₃. When the second electrode EL2 is formed as a reflective electrode, the second electrode EL2 may include a layer formed of one of Li, Ca, LiF/Ca, LiF/Al, Al, Ag, Mg, and a combination thereof. In an embodiment, a structure and a material of the second electrode EL2 may be modified in various ways.

Example embodiments of the invention have been disclosed herein, and although specific terms are employed, they are used and are to be interpreted in a generic and descriptive sense only and not for purpose of limitation. In some instances, as would be apparent to one of skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A thin film transistor (TFT) substrate structure, comprising:
a substrate;
a TFT on the substrate; and
an insulating layer including at least one dummy hole, the at least one dummy hole being situated in one or more of an upper area of the TFT or a peripheral area of the TFT,
an insulating material buried in the at least one dummy hole, the said insulating material being different from a material of the insulating layer.

2. A TFT substrate structure as claimed in claim 1, wherein the insulating layer includes at least one contact hole in which a conductive material is buried.

3. A TFT substrate structure as claimed in claim 2, wherein a width of the at least one dummy hole is substantially the same as a width of the at least one contact hole.

4. A TFT substrate structure as claimed in claim 2 or 3, wherein:
the TFT includes an active pattern on the substrate and a gate electrode that overlaps at least one portion of the active pattern,
the TFT substrate structure further includes a conductive layer that is electrically connected to the active pattern via the conductive material buried in the at least one contact hole, and
the insulating layer is an interlayer insulating layer situated between the gate electrode and the conductive layer.

5. A TFT substrate structure as claimed in claim 4, further comprising a planarizing layer that covers the insulating layer and the conductive layer,
wherein a portion of the planarizing layer is buried in the at least one dummy hole.

6. A TFT substrate structure as claimed in claim 4 or 5, further comprising a gate insulating layer between the active pattern and the gate electrode,
wherein the at least one dummy hole includes a first dummy hole that penetrates through the gate insulating layer and extends to an upper surface of the substrate.

7. A TFT substrate structure as claimed in claim 4, 5 or 6, wherein the at least one dummy hole includes a second dummy hole that extends to an upper surface of the gate electrode.

8. A TFT substrate structure as claimed in claim 4, further comprising:
a first gate insulating layer between the active pattern and the gate electrode, the first gate insulating layer including silicon oxide; and
a second gate insulating layer between the first gate insulating layer and the gate electrode, the second gate insulating layer including silicon nitride.

9. A TFT substrate structure as claimed in one of claims 4 to 8, wherein the gate electrode includes aluminum (Al).

10. A TFT substrate structure as claimed in claim 2, wherein:
the TFT includes an active pattern on the substrate and a gate electrode that overlaps at least one portion of the active pattern, and
the TFT substrate structure further includes:
a first conductive layer on the gate electrode, the first conductive layer including an upper electrode that overlaps at least one portion of the gate electrode, wherein the upper electrode and the gate electrode form a capacitor; and
a second conductive layer including a power line that is electrically connected to the upper electrode via the conductive material buried in the at least one contact hole, the power line being adapted to apply a power voltage to the upper electrode,
wherein the insulating layer is an interlayer insulating layer situated between the first and second conductive layers.

11. A TFT substrate structure as claimed in claim 10, further comprising a planarizing layer that covers the insulating layer and the second conductive layer,
wherein a portion of the planarizing layer is buried in the at least one dummy hole.

12. A TFT substrate structure as claimed in claim 10 or 11, further comprising:
a gate insulating layer between the active pattern and the gate electrode; and
a dielectric layer between the gate electrode and the first conductive layer,
wherein the at least one dummy hole includes a first dummy hole that penetrates through the gate insulating layer and the dielectric layer and extends to an upper surface of the surface.

13. A TFT substrate structure as claimed in claim 10, 11 or 12, wherein the at least one dummy hole includes a second dummy hole that extends to an upper surface of the upper electrode.

14. A TFT substrate structure as claimed in any preceding claim, wherein:
the insulating layer includes an inorganic insulating material, and
the material buried in the at least one dummy hole is an organic insulating material.

15. A TFT substrate structure as claimed in any preceding claim, wherein the dummy hole is circular, oval, or polygonal shaped.

16. A display apparatus, comprising:
the thin film transistor (TFT) substrate structure as claimed in any preceding claim; and
a display device on the TFT substrate structure.

17. A method of manufacturing a thin film transistor (TFT) substrate structure, the method comprising:
forming a TFT on a substrate;
forming an insulating layer including at least one dummy hole in one or more of an upper area of the TFT or a peripheral area of the TFT; and
burying, in the at least one dummy hole, an insulating material that is different from a material of the insulating layer.

18. A method as claimed in claim 17, wherein:
the insulating layer is formed such that it includes the at least one dummy hole and at least one contact hole, and
the method further includes burying a conductive material in the at least one contact hole.

19. A method as claimed in claim 18, wherein forming the insulating layer includes forming the at least one dummy hole and at least one contact hole to have substantially a same width.

20. A method as claimed in claim 18 or 19, wherein:
forming the TFT includes forming an active pattern on the substrate, and forming a gate electrode such that the gate electrode overlaps at least one portion of the active pattern,
burying the conductive material in the at least one contact hole includes forming a conductive layer electrically connected to the active pattern via the conductive material buried in the at least one contact hole, and
forming the insulating layer includes forming an interlayer insulating layer between forming the gate electrode and forming the conductive layer.

21. A method as claimed in claim 20, further comprising forming a planarizing layer that covers the insulating layer and the conductive layer, wherein a portion of the planarizing layer is buried in the at least one dummy hole.

22. A method as claimed in claim 20 or 21, further comprising forming a gate insulating layer between forming the active pattern and forming the gate electrode,
wherein forming the insulating layer further includes forming a first dummy hole that penetrates through the gate insulating layer and extends to an upper surface of the substrate.

23. A method as claimed in claim 20, 21 or 22, wherein forming the insulating layer includes:
coating an insulating material on the substrate; and
forming a second dummy hole that extends to an upper surface of the gate electrode.

24. A method as claimed in claim 17, wherein:
forming the insulating layer includes forming an insulating layer that includes an inorganic insulating material, and
the material buried in the at least one dummy hole is an organic insulating material.

25. A method as claimed in any one of claims 17 to 24, wherein the dummy hole is circular, oval, or polygonal shaped.

26. A method of manufacturing a display apparatus, the method comprising:
preparing a thin film transistor (TFT) substrate structure manufactured according to a method as claimed in any one of claims 17 to 25; and
forming a display device on the TFT substrate.
